# EUROPEAN PATENT APPLICATION

(11) **EP 2 608 232 A2**
(43) Date of publication of application: **26.06.2013**
(21) Application number: 12162217.9
(22) Date of filing: 29.03.2012
(51) Int. Cl.: H01G 9/20

(54) **Photoelectric module**

(30) Priority: 19.12.2011 US 201161577245 P; 20.03.2012 US 201213425401
(71) Applicant: Samsung SDI Co., Ltd., Yongin-si, Gyeonggi-do (KR)
(72) Inventor: Kim, Hyun-Chul, Gyeonggi-do (KR)
(74) Representative: Walaski, Jan Filip

(57) **Abstract**

A photoelectric module comprises a plurality of photoelectric cells, each comprising first and second substrates, first and second electrodes on respective ones of the first and second substrates, a sealing member between the first and second electrodes, a first electrode terminal extending from the first electrode on a first side of the cell and a second electrode terminal extending from the second electrode on a second side of the cell opposite the first side, wherein the plurality of cells are positioned such that the first electrode terminal of a first cell is adjacent to the second electrode terminal of a second adjacent cell and the second electrode terminal of the first cell is adjacent to the first electrode terminal of the second adjacent cell.

## Description

The present invention relates to a photoelectric module.

Extensive research has recently been conducted on photoelectric devices that convert light into electric energy. From among such devices, solar cells have attracted much attention as alternative energy sources to fossil fuels.

As research on solar cells having various working principles has been continuously conducted, wafer-based silicon or crystalline solar cells using a p-n semiconductor junction have appeared to be the most prevalent ones. However, the manufacturing costs of wafer-based crystalline silicon or solar cells are high because they are formed of a high purity semiconductor material.

Unlike silicon solar cells, dye-sensitized solar cells include a photosensitive dye that receives visible light and generates excited electrons, a semiconductor material that receives the excited electrons, and an electrolyte that reacts with electrons returning from an external circuit. Since dye-sensitized solar cells have much higher photoelectric conversion efficiency than other conventional solar cells, the dye-sensitized solar cells are viewed as the next-generation solar cells. To obtain a high photo-electromotive power, solar cells may be modularized by electrically connecting a plurality of cells. According to connection structures that electrically connect the modularized solar cells, dead areas are formed, and a connection operation of the solar cells may be difficult to perform.

One or more embodiments of the present invention include photoelectric modules, in which dead areas formed in connection structures that electrically connect a plurality of modularized cells are reduced.

One or more embodiments of the present invention include photoelectric modules in which a connection operation of electrically connecting a plurality of cells is easily performed.

According to the invention, there is provided a photoelectric module comprising a plurality of photoelectric cells, each comprising first and second substrates, first and second electrodes on respective ones of the first and second substrates, a sealing member between the first and second electrodes, a first electrode terminal extending from the first electrode on a first side of the cell and a second electrode terminal extending from the second electrode on a second side of the cell opposite the first side, wherein the plurality of cells are positioned such that the first electrode terminal of a first cell is adjacent to the second electrode terminal of a second adjacent cell and the second electrode terminal of the first cell is adjacent to the first electrode terminal of the second adjacent cell.

In other words the plurality of cells are arranged in alternating/reversed patterns where positions of the first and second electrode terminals are switched left and right along a direction of arrangement of the cells.

The first and second substrates may be offset from one another lengthwise such that end portions of the respective first and second substrates extend beyond the sealing member in opposite directions, and the first and second electrode terminals are arranged on the respective end portions.

The first and second electrode terminals may be integrally formed with the respective first and second electrodes.

Each of the first and second electrodes may comprise one or more frames, wherein the frames may be aligned with one another.

The first and second electrodes and the sealing member may be stacked together with the first electrode uppermost, wherein the first electrode terminal protrudes to one side of the stack and the second electrode terminal protrudes to the other side of the stack.

The photoelectric module may further comprise a connection member arranged to electrically connect the first and second electrode terminals of adjacent cells.

The connection member may comprise a flexible connection member, such as a wire, or may comprise a substantially rigid connection member, such as a bar or a rod. The precise shape of the bar/rod may vary, for example the rod may have a square, rectangular or other polygonal profile, while the rod may have a circular, oval or similar cross-section or may be substantially cylindrical but with flattened surfaces for providing a good electrical connection.

An upper surface of the connection member may be arranged to contact the first electrode terminal forming an upper electrode terminal of a first cell, and a lower surface of the connection member may be arranged to contact the second electrode terminal forming a lower electrode terminal of an adjacent second cell.

The photoelectric module may further comprise a support disposed on the second substrate forming a lower substrate of the first cell for supporting a lower surface of the connection member at the first cell.

The lower substrate may be longer than the upper substrate and may extend to form a base for the support. The support comprises the same material as the electrode on the lower substrate and is spaced apart from and electrically isolated from the electrode on the lower substrate.

According to the embodiments of the present invention, dead areas formed in connection structures for electrically connecting a plurality of modularized cells may be reduced. In addition, a connection operation of electrically connecting a plurality of cells may be easily performed.

Embodiments of the invention will now be described by way of example with reference to the accompanying drawings, in which:
FIG. 1 is a perspective view of a photoelectric module according to an embodiment of the present invention;
FIG. 2 is a disassembled perspective view of a cell of the photoelectric module of FIG. 1;
FIG. 3 is a cross-sectional view illustrating the cell of FIG. 2, cut along a line III-III;
FIG. 4 is a perspective view of a photoelectric module according to another embodiment of the present invention;
FIG. 5 is a disassembled perspective view of a cell of the photoelectric module of FIG. 4;
FIG. 6 is a perspective view illustrating a connection structure of adjacent cells in the photoelectric module of FIG. 4; and
FIG. 7 is a cross-sectional view of the cell of FIG. 5 cut along a line VII-VII.

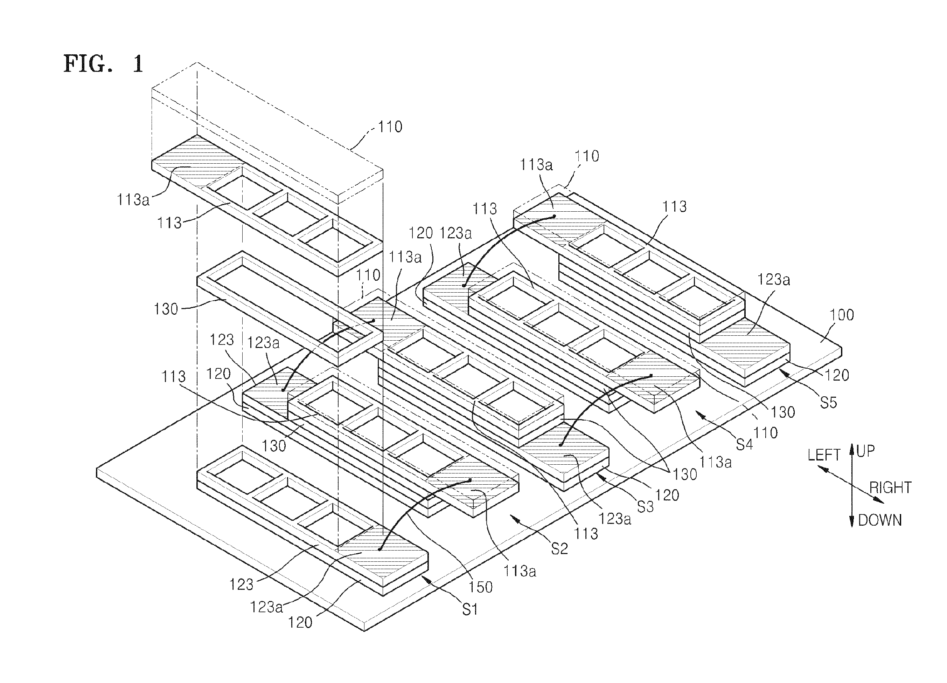

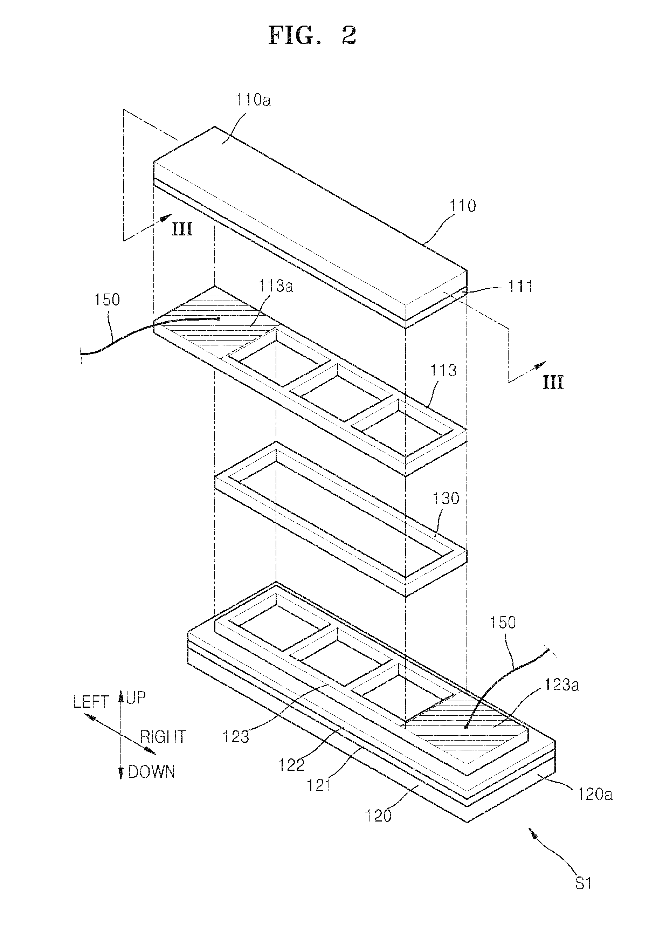

Referring to FIGS. 1 and 2, the photoelectric module includes at least two cells, that is, a plurality of cells S1, S2, S3, S4, and S5 in this embodiment, and a group of the cells S1, S2, S3, S4, and S5 may be connected in series or parallel in a module. For example, a group of the cells S1, S2, S3, S4, and S5 may be arranged in rows on a support substrate 100 and may be electrically connected to one another via a connection member 150. For example, the group of the cells S1, S2, S3, S4, and S5 may be connected serially as first electrodes 113 and second electrodes 123 of respective adjacent cells S1, S2, S3, S4, and S5 are connected to each other.

Referring to FIG. 2, the cells S1, S2, S3, S4, and S5 forming the photoelectric module, for example, the cell S1 is illustrated. Although only the first cell S1 is illustrated in FIG. 2, the other cells S2, S3, S4, and S5 may have substantially the same structure, and thus, a description thereof applies to the cells S2, S3, S4, and S5.

The first cell S1 includes a first substrate 110 on which the first electrode 113 is formed and a second substrate 120 on which the second electrode 123 is formed.

The first substrate 110 and the second substrate 110 are arranged in a vertical direction and may be coupled to face each other with a sealing member 130 therebetween. The first and second electrodes 113 and 123 may include first and second electrode terminals 113a and 123a, respectively, extending from the first and second electrodes 113 and 123 in opposite left and right directions. In this specification, the first and second electrode terminals 113a and 123a extending from the first and second electrodes 113 and 123 indicate that the first and second electrode terminals 113a and 123a are electrically connected to the first and second electrodes 113 and 123.

The first and second substrates 110 and 120 are coupled to face each other with the sealing member 130 therebetween, and an electrolyte may be filled in space formed by coupling the first and second substrates 110 and 120 with the sealing member 130 therebetween. An inner area surrounded by the sealing member 130 may be used as a photoelectric conversion unit that absorbs incident light to generate a photocurrent.

The first and second electrode terminals 113a and 123a are formed on left and right sides of the sealing member 130, respectively; for example, the first and second electrode terminals 113a and 123a may be formed on opposite sides in a length direction (left-right direction). For example, when assuming that the cell S1 has an overall rectangular shape including a pair of long side portions and a pair of short side portions, the first and second electrode terminals 113a and 123a may be formed as the short side portions of the cell S1.

The first and second electrode terminals 113a and 123a are formed to electrically connect the structurally individualized cells S1, S2, S3, S4, and S5. In detail, a first electrode terminal 113a of a cell and a second electrode terminal 123a of another adjacent cell are electrically connected to each other such that a group of the cells forms a photoelectric module. For example, the first and second electrode terminals 113a and 123a may electrically connect the cells S1, S2, S3, S4, and S5 via the connection member 150 extending in a direction of arrangement of the cells S1, S2, S3, S4, and S5.

The first and second electrode terminals 113a and 123a may be a single unit with the first and second electrodes 113 and 123 and may extend from the first and second electrodes 113 and 123 to the outside of the sealing member 130. For example, the first electrode 113 may be formed on the first substrate 110, which is a light-receiving surface, and may be used as a negative electrode that withdraws excitation electrons generated by light. Thus, the first electrode terminal 113a that extends from the first electrode 113 may form a negative electrode terminal.

The second electrode 123 may be formed on the second substrate 120 that is opposite to the light-receiving surface and may be used as a positive electrode that receives a current flow that has passed through an external circuit. Thus, the second electrode terminal 123a extending from the second electrode 123 may form a positive electrode terminal.

In the group of the cells S1, S2, S3, S4, and S5 forming the photoelectric module, the first and second electrode terminals 113a and 123a of the adjacent cells S1, S2, S3, S4, and S5, that is, the first and second electrode terminals 113a and 123a having opposite polarities may be electrically connected to each other to form a serial connection, and a high output photo-electromotive power may be obtained.

The first and second electrode terminals 113a and 123a are formed on end portions 110a and 120a of the first and second substrates 110 and 120, respectively. For example, the end portions 110a and 120a of the first and second substrates 110 and 120, on which the first and second electrode terminals 113a and 123a are formed, respectively, extend from the first and second substrates 110 and 120 that face each other, by being offset from the opposite first and second substrates 110 and 120. For example, the end portion 110a of the first substrate 110, on which the first electrode terminal 113a is formed, and/or the end portion 120a of the second substrate 120, on which the second electrode terminal 123a is formed, may extend offset from the second substrate 120 and/or the first substrate 110 that are opposite thereto.

Referring to FIG. 2, the end portion 110a of the first substrate 110 on which the first electrode terminal 113a is formed on the left of the sealing member 130 extends offset from the second substrate 120. Also, the end portion 120a of the second substrate 120 on which the second electrode terminal 123a is formed on the right of the sealing member 130 extends offset from the first substrate 110.

For example, the first and second substrates 110 and 120 may be coupled to each other in an offset form along the length direction, and the end portions 110a and 120a may extend offset from opposite substrates, that is, the second and first substrates 120 and 110, respectively. For example, the end portion 110a of the first substrate 110 on the left of the sealing member 130 may protrude outside the second substrate 120, and the end portion 120 of the second substrate 120 on the right of the sealing member 130 may protrude outside the first substrate 110. By forming the first and second electrode terminals 113a and 123a on the end portions 110a and 120a of the first and second substrates 110 and 120, respectively, to extend offset from respective opposite substrates, physical interference may be reduced when connecting the first and second terminals 113a and 123a.

Referring to FIG. 1, the adjacent cells S1, S2, S3, S4, and S5 are arranged in reversed patterns where positions of the first and second electrode terminals 113a and 123a thereof are switched left and right. For example, the cells S1, S2, S3, S4, and S5 are placed on the substrate 100 at a 180 degree difference.

For example, the second electrode terminal 123a of the cell S1 and the first electrode terminal 113a of the cell S2 are arranged adjacent to each other on the same side of the sealing member 130, that is, on the right side of the sealing member 130.

Similarly, the second electrode terminal 123a of the cell S2 and the first electrode terminal 113a of the cell S3 are arranged adjacent to each other on the same side of the sealing member 130, that is, on the left side of the sealing member 130.

Likewise, the second electrode terminal 123a of the cell S3 and the first electrode terminal 113a of the cell S4 are arranged adjacent to each other on the same side of the sealing member 130, that is, on the right side of the sealing member 130.

By arranging the cells S1, S2, S3, S4, and S5 such that the first and second electrode terminals 113a and 123a of opposite polarities are adjacently connected on the left side or on the right side of the sealing member 130, the group of the cells S1, S2, S3, S4, and S5 may be serially connected. The first and second electrode terminals 113a and 123a of the adjacent cells S1, S2, S3, S4, and S5 may be electrically connected to each other via the connection members 150; in detail, the connection members 150 may be alternately formed on the left and on the right of the sealing member 130 along the arrangement direction of the cells S1, S2, S3, S4, and S5 to electrically connect the adjacent cells S1, S2, S3, S4, and S5.

The connection members 150 may be formed of various materials as long as the materials have electrical conductivity and may be formed of a metal having a high conductivity, such as copper. For example, the connection members 150 may be formed of a flexible metal wire or may be formed of a hard metal.

The connection members 150 formed as a metal wire may be useful in connecting the adjacent cells S1, S2, S3, S4, and S5, for example, in terms of facilitating welding thereof. For example, by welding a first end of the connection member 150 to the first electrode terminal 113a of one of the cells S1, S2, S3, S4, and S5, and welding a second end of the connection member 150 to the second electrode terminal 123 of another adjacent one of the cells S1, S2, S3, S4, and S5, the first and second electrode terminals 113a and 123a may be electrically connected to each other.

Here, by using a flexible connection member 150, welding of the first and second electrode terminals 113a and 123a may be easily performed.

The connected first and second electrode terminals 113a and 123a are supported by the first and second substrates 110 and 120 or the end portions 110a and 120a thereof of the adjacent cells S1, S2, S3, S4, and S5, and thus, for example, the second electrode terminal 123a formed on the second substrate 120 in a lower portion of the cell S1 and the first electrode terminal 113a formed under the first substrate 110 in an upper portion of the cell S2 may be connected diagonally via the connection member 150, formed as a metal wire. That is, the connection member 150 may extend diagonally to connect the first and second electrode terminals 113a and 123a of the adjacent cells S1, S2, S3, S4, and S5, which are spaced apart in the vertical direction.

Referring to FIG. 1, the connection member 150 electrically connects each pair of adjacent cells S1, S2, S3, S4, and S5, and a plurality of connection members 150 may be formed to connect different pairs of the cells S1, S2, S3, S4, and S5. According to the direction of arrangement of the cells S1, S2, S3, S4, and S5, the plurality of connection members 150 between the adjacent cells S1, S2, S3, S4, and S5 are alternately arranged on the left and right sides of the photoelectric module. For example, along the direction of arrangement of the cells S1, S2, S3, S4, and S5, the connection member 150 between the cell S1 and the cell S2 is formed on the right side of the photoelectric module, and the connection member 150 between the cell S2 and the cell S3 is formed on the left side of the photoelectric module. Also, the connection member 150 between the cell S3 and the cell S4 is formed on the right side of the photoelectric module again.

For example, the cells S1, S2, S3, S4, and S5 that form the photoelectric module may have a rectangular shape having a pair of long side portions and a pair of short side portions, and the connection member 150 connects the short side portions of the cells S1, S2, S3, S4, and S5, that is, the first and second electrode terminals 113a and 123a formed as the short side portions of the cells S1, S2, S3, S4, and S5.

As described above, as the connection member 150 electrically connects the short side portions of the cells S1, S2, S3, S4, and S5, dead areas of the photoelectric module formed due to the connection structure, that is, dead areas which do not contribute to photoelectric conversion according to reception of incident light may be reduced, and a light output efficiency per a unit surface area may be increased.

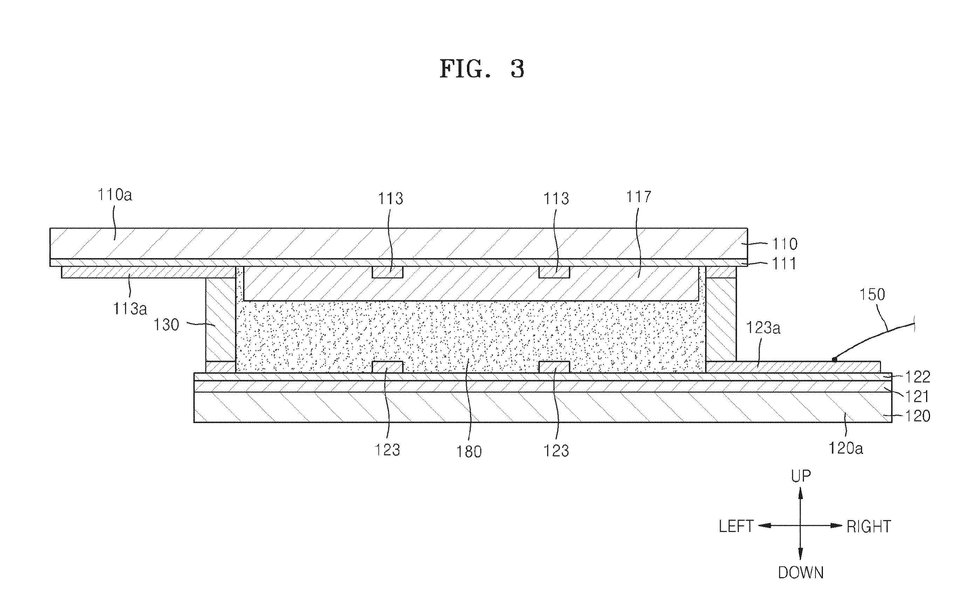

For example, if the first and second electrode terminals 113a and 123a are formed as the long side portions of the cells S1, S2, S3, S4, and S5 instead of as the short side portions, and the connection member 150 connects the long side portions of each of the cells, a surface area for a connection structure is increased along a length direction of the long side portions, and thus, dead areas of the photoelectric module are increased. FIG. 3 is a cross-sectional view illustrating the cell S1 of FIG. 2, cut along a line III-III. The components of the cell S1 are described as follows in detail below with reference to FIG. 3.

The first and second substrates 110 and 120 may be formed of a transparent material having a high light transmitting rate. For example, the first and second substrates 110 and 120 may be formed of a glass substrate or a resin film. A resin film usually has flexibility, and thus, is appropriate for use where flexibility is required.

First and second conductive layers 111 and 121 may be formed of a transparent conductive material having electrical conductivity and optical transparency on the first and second substrates 110 and 120, respectively. For example, the first and second conductive layers 111 and 121 may be formed of a transparent conductive oxide (TCO) such as indium tin oxide (ITO), fluorinated tin oxide (FTO), or antimony tin oxide (ATO).

The first and second electrodes 113 and 123 may be formed of an opaque metal having a high electrical conductivity, such as aluminum (Al) or silver (Ag), on the first and second substrates 110 and 120, respectively.

Although not shown in FIG. 3, a protection layer may be formed on surfaces of the first and second electrodes 113 and 123. The protection layer prevents corrosion of the first and second electrodes 113 and 123 and may be formed of a material that does not react with an electrolyte 180. For example, the protection layer may be formed of a glass frit.

A light-absorbing layer 117 may be formed adjacent to the first electrode 113. For example, the light-absorbing layer 117 may be formed on the first electrode 113 and may include a semiconductor layer and a photosensitive dye that is adsorbed on the semiconductor layer. For example, the semiconductor layer may be formed of a metal oxide of Cd, Zn, In, Pb, Mo, W, Sb, Ti, Ag, Mn, Sn, Zr, Sr, Ga, Si, Cr.

For example, the photosensitive dye adsorbed in the semiconductor layer absorbs a visible light band and may be formed of molecules that cause quick electron transfer from a light excitation state to the semiconductor layer. For example, a ruthenium-based dye may be used as the photosensitive dye.

A reduction catalyst layer 122 may be formed between the second substrate 120 and the second electrode 123. The reduction catalyst layer 122 may be formed of a material that has a reduction-catalyzing function and provides electrons to the electrolyte 180. The reduction catalyst layer 122 may be formed of a metal such as platinum (Pt), gold (Au), silver (Ag), copper (Cu), aluminium (Al), a metal oxide such as tin oxide, or a carbonaceous material such as graphite. The electrolyte 180 between the light-absorbing layer 117 and the reduction catalyst layer 122 may include a Redox electrolyte including a pair of an oxidant and a reducing agent.

The first and second electrodes 113 and 123 including the first and second electrode terminals 113a and 123a extend to the outside of the sealing member 130; the first and second electrode terminals 113a and 123a may be formed on left and right sides of the sealing member 130, respectively. After the first and second electrode terminals 113a and 123a are formed, the end portions 110a and 120a of the first and second substrates 110 and 120, on which the first and second electrode terminals 113a and 123a are formed, may respectively extend offset from the second and first substrates 110 and 120. Because the first and second electrode terminals 113a and 123a are formed on the end portions 110a and 120a of the first and second substrates 110 and 120 to respectively extend offset from opposite substrates, physical interference may be reduced when connecting the first and second electrode terminals 113a and 123a.

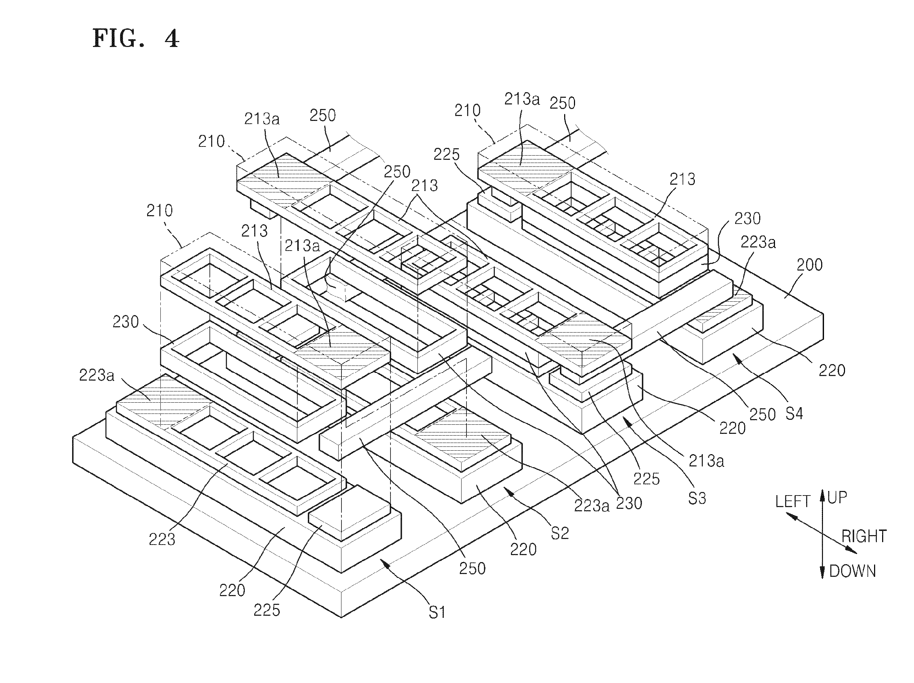

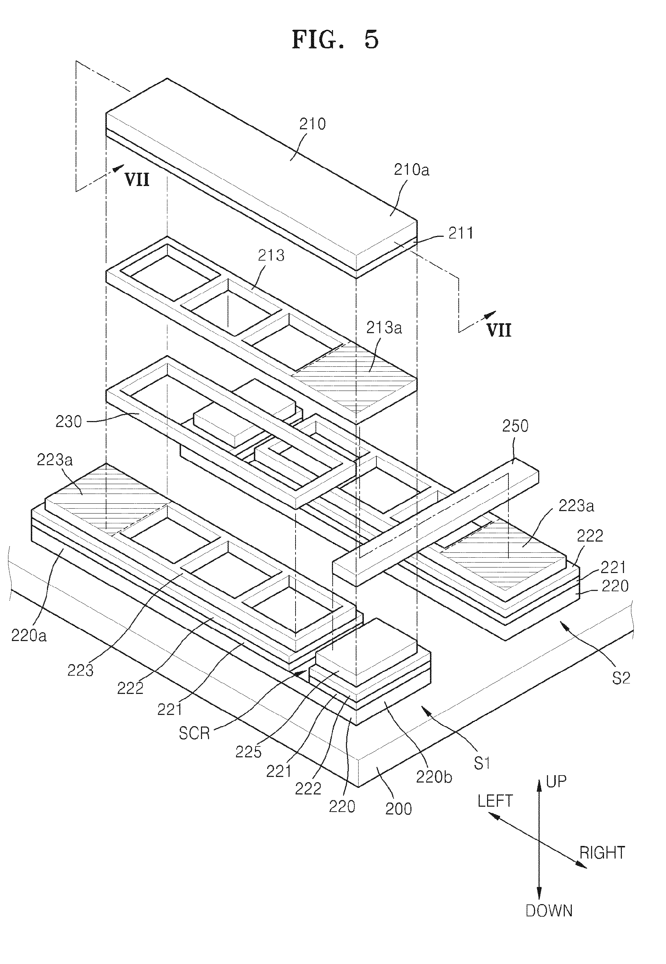

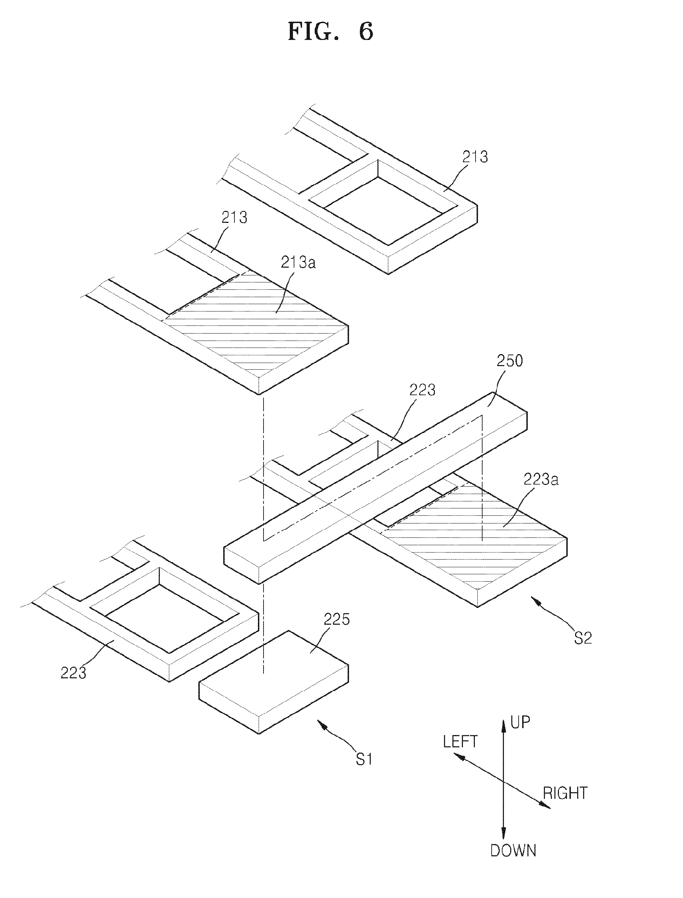

FIG. 4 is a disassembled perspective view of a photoelectric module according to another embodiment of the present invention. FIG. 5 is a disassembled perspective view of a cell S1 of the photoelectric module of FIG. 4. FIG. 6 is a perspective view illustrating an electrical connection structure of the cell S1 of the photoelectric module of FIG. 5.

Referring to FIGS. 4 and 5, the photoelectric module includes a plurality of cells S1, S2, S3, and S4 in this embodiment, and a group of the cells S1, S2, S3, and S4 may be connected in series or parallel in a module. For example, a group of the cells S1, S2, S3, and S4 may be arranged in rows on a support substrate 200 and may be electrically connected to one another via connection members 250. For example, the group of the cells S1, S2, S3, and S4 may be connected serially via first electrodes 213 and second electrodes 223 of respective adjacent cells S1, S2, S3, and S4 that are connected to each other.

Referring to FIG. 5, one of the cells S1, S2, S3, and S4 forming the photoelectric module, for example, the cell S1 is illustrated. Although only the cell S1 is illustrated in FIG. 5, the other cells S2, S3, and S4 have substantially the same structure, and thus, a description of the cell S1 applies to the cells S2, S3, and S4.

The cell S1 forming the photoelectric module includes a first substrate 210 on which the first electrode 213 is formed and a second substrate 220 on which the second electrode 223 is formed, and the first and second substrates 210 and 220 may be coupled to face each other with a sealing member 230 therebetween. The first and second electrodes 213 and 223 may include first and second electrode terminals 213a and 223a, respectively, extending outside of the sealing member 230 in opposite left and right directions. In this specification, the first and second electrode terminals 213a and 223a extending from the first and second electrodes 213 and 223 indicate that the first and second electrode terminals 213a and 223a are electrically connected to the first and second electrodes 213 and 223.

The first and second substrates 210 and 220 are coupled to face each other with the sealing member 230 therebetween, and an electrolyte (not shown) may be filled in space formed by coupling the first and second substrates 210 and 220 with the sealing member 230 therebetween. An inner area surrounded by the sealing member 230 may be used as a photoelectric conversion unit that absorbs incident light to generate a photocurrent.

The first and second electrode terminals 213a and 223a are formed on left and right sides of the sealing member 230, respectively; for example, the first and second electrode terminals 213a and 223a may be formed on opposite sides in a length direction (left-right direction). The first and second electrode terminals 213a and 223a are electrically connected to the first and second electrodes 213 and 223 and may have the same polarities as those of the first and second electrodes 213 and 223, respectively.

In detail, the first electrode terminal 213a may extend from the first electrode 213, which is a light negative electrode, and may form a negative electrode terminal for withdrawing excitation electrons generated by light. The second electrode terminal 223a may extend from the second electrode 223, which is an opposite electrode, to form a positive electrode terminal that receives a current flow that has passed through an external circuit.

By connecting the first and second electrode terminals 213a and 223a having opposite polarities between the adjacent cells S1, S2, S3, and S4, a photoelectric module, in which a group of the cells S1, S2, S3, and S4 are serially connected, may be formed, and a high output photoelectromotive power may be obtained according to the number of cells S1, S2, S3, and S4. Here, the first and second electrode terminals 213a and 223a of the adjacent cells S1, S2, S3, and S4 may be connected to each other via the connection member 250.

The first and second electrode terminals 213a and 223a may be a single unit with the first and second electrodes 213 and 223 and extend from the first and second electrodes 213 and 223. However, as long as the first and second electrode terminals 213a and 223a are electrically connected to the first and second electrodes 213 and 223, respectively, a connection structure of the first and second electrode terminals 213a and 223a and the first and second electrodes 213 and 223 is not limited.

The first and second electrode terminals 213a and 223a are formed on end portions 210a and 220a of the first and second substrates 210 and 220, respectively. The end portions 210a and 220a of the first and second substrates 210 and 220, on which the first and second electrode terminals 213a and 223a are formed, respectively, extend offset from respective opposite substrates. Referring to the embodiment of FIG. 5, the end portion 220a of the second substrate 220 on which the second electrode terminal 223a is formed extends offset from the first substrate 210.

For example, the first and second substrates 210 and 220 may be formed to have different lengths. For example, the second substrate 220 may be longer than the first substrate 210, and the end portion 220a of the second substrate 220 on the left side may extend offset from the first substrate 210. By forming the second electrode terminal 223a on the end portion 220a of the second substrate 220 on the left side to extend offset from the first substrate 210, physical interference may be reduced when connecting the first and second electrode terminals 210a and 220a.

Besides the second electrode terminal 223a connected to the second electrode 223 and formed on the end portion 220a of the second substrate 220 on the left, an isolation electrode 225 that is separated from the second electrode 223 is formed on the end portion 220b of the second substrate 220 on the right side. The isolation electrode 225 is electrically insulated from the second electrode 223 and may be spatially separated from the second electrode 223 by, for example, a scribing gap SCR. After the second electrode terminal 223a and the isolation electrode 225 are formed as a single unit with the second electrode 223, the isolation electrode 225 may be separated from the second electrode 223 by laser scribing.

By separating the isolation electrode 225 from the second electrode 223, an inner short circuit between the first electrode terminal 213a and the isolation electrode 225 arranged in a vertical direction of the same cell S1 may be prevented. For example, a positive-negative electrode short circuit is likely to occur in the first and second electrodes 213 and 223 of the same cell S1 due to the connection member 250 that extends between the first electrode terminal 213a and the isolation electrode 225.

As illustrated in FIG. 6, the connection member 250 that extends between the first electrode terminal 213a of the cell S1 and the isolation electrode 225 forms an electrical contact point with the second electrode terminal 223a of the cell S2, and thus, the cells S1 and S2 may be electrically connected via the connection member 250.

Although the connection member 250 extends between the first electrode terminal 213a and the isolation electrode 225 of the cell S1, it does not cause a short circuit between positive and negative electrodes between the first electrode terminal 213a and the isolation electrode 225. While the first electrode terminal 213a is connected to the first electrode 213, the isolation electrode 225 is electrically insulated from the second electrode 223, and thus, a short circuit between the first and second electrodes 213 and 223 of the cell S1 is not caused.

Referring to FIG. 4, the cells S1, S2, S3, and S4 adjacent to one another are arranged reversed patterns where positions of the first and second electrode terminals 213a and 223a thereof are switched left and right. For example, the cells S1, S2, S3, and S4 are placed on the substrate 200 at a 180 degree difference.

The first electrode terminal 213a of the cell S1 and the second electrode terminal 223a of the cell S2 are arranged adjacent to each other on the same side of the sealing member 230, that is, on the right side of the sealing member 230.

Similarly, the first electrode terminal 213a of the cell S2 and the second electrode terminal 223a of the cell S3 are arranged adjacent to each other on the same side of the sealing member 230, that is, on the left side of the sealing member 230.

Likewise, the first electrode terminal 213a of the cell S3 and the second electrode terminal 223a of the cell S4 are arranged adjacent to each other on the same side of the sealing member 230, that is, on the right side of the sealing member 230.

By arranging the first and second electrode terminals 213a and 223a of opposite polarities of the cells S1, S2, S3, and S4 to be adjacently connected to one another on the left side or on the right side of the sealing member 230, the group of the cells S1, S2, S3, and S4 may be serially connected. The first and second electrode terminals 213a and 223a of the cells S1, S2, S3, and S4 adjacent to one another may be electrically connected to each other via the connection member 250; in detail, the connection members 250 may be alternately formed on the left and on the right sides of the sealing member 230 along the arrangement direction of the cells S1, S2, S3, and S4 to electrically connect the adjacent cells S1, S2, S3, and S4.

The connection member 250 may be formed of various materials as long as the materials have electrical conductivity and may be formed of a metal having a high conductivity, such as copper.

For example, the connection member 250 may be formed of a bar or rod member that extends along a predetermined direction. For example, a connection member 250 having a shape of a rod member may extend along the arrangement direction of cells and connects adjacent first and second electrode terminals 213a and 223a to each other. For example, the connection members 250 between the first electrode terminals 213a and the isolation electrodes 250 of the same cells extend between the adjacent cells S1, S2, S3, and S4, and form an electrical contact point with the second electrode terminals 223a of the adjacent cells S1, S2, S3, and S4.

For example, the connection member 250 extends between the first electrode terminal 213a and the isolation electrode 225 of the cell S1 and may form an electrical contact point with the second electrode terminal 223a of the cell S2. Also, another connection member 250 extends between the first electrode terminal 213a and the isolation electrode 225 of the cell S2 and may form an electrical contact point with the second electrode terminal 223a of the cell S3.

The precise shape of the bar/rod forming a rigid connection member may vary, for example the bar may have a square, rectangular or other polygonal profile, while the rod may have a circular, oval or similar cross-section or may be substantially cylindrical but with flattened surfaces for providing a good electrical connection. Other shapes that fulfil the functional requirements are also envisaged.

As described above, even when the connection members 250 extend between the first electrode terminals 213a and the isolation electrodes 225 of the same cells, an inner short circuit therebetween is not generated, because, although the connection member 250 is connected to the first electrode 213 via the first electrode terminal 213a, the connection member 250 is not connected to the second electrode 223 via the isolation electrode 225. As described above, the isolation electrode 225 is separated from the second electrode 223 and is insulated from the second electrode 223.

The connection member 250 between the cells S1, S2, S3, and S4 is alternately arranged on the left and right sides of the photoelectric module along an arrangement direction of the cells S1, S2, S3, and S4. For example, along the arrangement direction of the cells S1, S2, S3, and S4, the connection member 250 between the cells S1 and S2 is formed on the right side of the photoelectric module, and the connection member 250 between the cells S2 and S3 is formed on the left side of the photoelectric module. The connection member 250 between the cells S3 and S4 is formed on the right side of the photoelectric module again.

For example, the cells S1, S2, S3, and S4 that form the photoelectric module may have a rectangular shape having a pair of long side portions and a pair of short side portions, and the connection member 250 connects the short side portions of the cells S1, S2, S3, and S4, that is, the first and second electrode terminals 213a and 223a formed as the short side portions of the cells S1, S2, S3, and S4.

As described above, as the connection member 250 electrically connects the short side portions of the cells S1, S2, S3, and S4, dead areas of the photoelectric module formed due to the connection structure, that is, dead areas which do not contribute to photoelectric conversion according to reception of incident light may be reduced, and a light output efficiency with respect to a unit surface area may be increased.

For example, if the first and second electrode terminals 213a and 223a are formed as the long side portions of the cells S1, S2, S3, and S4 instead of as the short side portions, and the connection member 250 connects the long side portions of each of the cells S1, S2, S3, and S4, a surface area for a connection structure is increased along a length direction of the long side portions, and thus, dead areas of the photoelectric module are increased.

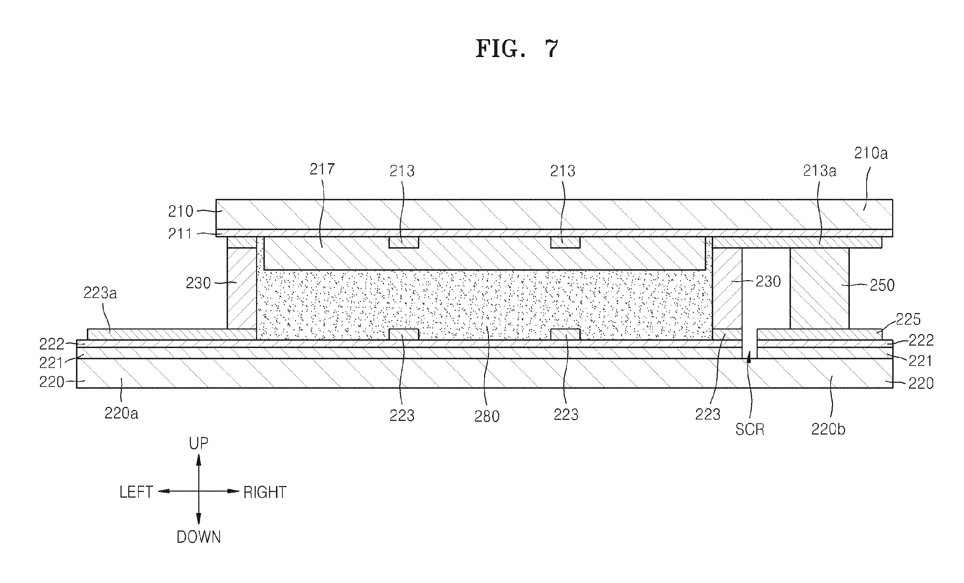

FIG. 7 is a cross-sectional view of the cell S1 of FIG. 5 cut along a line VII-VII. The components of the cell S1 are described as follows in detail with reference to FIG. 7.

The first and second substrates 210 and 220 may be formed of a transparent material having a high light transmitting rate. For example, the first and second substrates 210 and 220 may be formed of a glass substrate or a resin film. A resin film usually has flexibility, and thus, is appropriate for use where flexibility is required.

First and second conductive layers 211 and 221 formed on the first and second substrates 210 and 220, respectively, may be formed of a transparent conductive material having electrical conductivity and optical transparency. For example, the first and second conductive layers 211 and 221 may be formed of a TCO, such as ITO, FTO, or ATO.

The first and second electrodes 213 and 223 formed on the first and second substrates 210 and 220, respectively, may be formed of an opaque metal having a high electrical conductivity, such as Al or Ag.

Although not shown in FIG. 7, a protection layer may be formed on surfaces of the first and second electrodes 213 and 223. The protection layer prevents corrosion of the first and second electrodes 213 and 223 and may be formed of a material that does not react with an electrolyte 280. For example, the protection layer may be formed of a glass frit.

A light-absorbing layer 217 may be formed adjacent to the first electrode 213. For example, a light-absorbing layer 217 may be formed on the first electrode 213 and may include a semiconductor layer and a photosensitive dye that is adsorbed on the semiconductor layer. For example, the semiconductor layer may be formed of a metal oxide of Cd, Zn, In, Pb, Mo, W, Sb, Ti, Ag, Mn, Sn, Zr, Sr, Ga, Si, Cr.

For example, the photosensitive dye adsorbed in the semiconductor layer absorbs a visible light band and may be formed of molecules that cause quick electron transfer from a light excitation state to the semiconductor layer. For example, a ruthenium-based dye may be used as the photosensitive dye.

A reduction catalyst layer 222 may be formed between the second substrate 220 and the second electrode 223. The reduction catalyst layer 222 may be formed of a material that has a reduction-catalyzing function and provides electrons to the electrolyte 280. The reduction catalyst layer 222 may be formed of a metal such as platinum (Pt), gold (Au), silver (Ag), copper (Cu), aluminum (Al), a metal oxide such as tin oxide, or a carbonaceous material such as graphite. The electrolyte 280 between the light-absorbing layer 217 and the reduction catalyst layer 222 may include a Redox electrolyte including a pair of an oxidant and a reducing agent.

The first and second electrodes 213 and 223 including the first and second electrode terminals 213a and 223a extend to the outside of the sealing member 230, and the first and second electrode terminals 213a and 223a may be formed on opposite, left and right sides of the sealing member 230.

For example, the end portion 220a of the second substrate 220 on the left side on which the second electrode terminal 223a is formed may extend offset from the first substrate 210 of the same cell, and by forming the second electrode terminal 223a on the end portion 220a of the second substrate 220 on the left, physical interference due to the first substrate 210 may be reduced when connecting the first and second electrode terminals 210a and 220a.

For example, the isolation electrode 225 that is separated from the second electrode 223 is formed on the end portion 220b of the second substrate 220 on the right. The isolation electrode 225 may be electrically insulated via the scribing gap SCR from the second electrode 223 and the reduction catalyst layer 222 and the second conductive layer 221 which are electrically connected to the second electrode 223. For example, the second conductive layer 221, the reduction catalyst layer 222, and the second electrode 223 may be formed on the second substrate 220 at the same time, and then a scribing gap SCR may be formed to remove portions corresponding to the scribing gap SCR by laser scribing, thereby forming the isolation electrode 225 that is electrically insulated from the second electrode 223. Accordingly, a short circuit between positive and negative electrodes due to the connection member 250 extended via the first electrode terminal 213a and the isolation electrode 225 is not generated. The isolation electrode 225 provides support for a lower surface of the connection member 250. A support 225 may also be formed in alternative ways.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A photoelectric module comprising:
a plurality of photoelectric cells, each comprising:
first and second substrates (110, 120; 210, 220);
first and second electrodes (113, 123; 213, 223) on respective ones of the first and second substrates;
a sealing member (130, 230) between the first and second electrodes;
a first electrode terminal (113a, 213a) extending from the first electrode on a first side of the cell; and
a second electrode terminal (123a, 223a) extending from the second electrode on a second side of the cell opposite the first side;
wherein the plurality of cells are positioned such that the first electrode terminal (113a, 213a) of a first cell is adjacent to the second electrode terminal (123a, 223a) of a second adjacent cell and the second electrode terminal (123a, 223a) of the first cell is adjacent to the first electrode terminal (113a, 213a) of the second adjacent cell.

2. The photoelectric module of claim 1, wherein the first and second substrates are offset from one another lengthwise such that end portions (l1oa, 120a) of the respective first and second substrates extend beyond the sealing member (130, 230) in opposite directions, and the first and second electrode terminals (113a, 123a; 213a, 223a) are arranged on the respective end portions.

3. The photoelectric module of claim 1 or 2, wherein the first and second electrode terminals (113a, 123a; 213a, 223a) are integrally formed with the respective first and second electrodes (113, 123; 213, 223).

4. The photoelectric module of any one of the preceding claims, wherein each of the first and second electrodes (113, 123; 213, 223) comprise one or more frames, wherein the frames may be aligned with one another.

5. The photoelectric module of any one of the preceding claims, wherein the first and second electrodes (113, 123; 213, 223) and the sealing member (130, 230) are stacked together with the first electrode uppermost, the first electrode terminal (113a, 213a) protrudes to one side of the stack and the second electrode terminal (123a, 223a) protrudes to the other side of the stack.

6. The photoelectric module of any one of the preceding claims, further comprising a connection member (150, 250) arranged to electrically connect the first and second electrode terminals (113a, 123a; 213a, 223a) of adjacent cells.

7. The photoelectric module of claim 6, wherein the connection member comprises a flexible connection member (150).

8. The photoelectric module of claim 6, wherein the connection member comprises a substantially rigid connection member (250).

9. The photoelectric module of claim 8, wherein the connection member comprises a bar or rod (250).

10. The photoelectric module of claim 8 or 9, wherein an upper surface of the connection member (250) is arranged to contact the first electrode terminal (213a) forming an upper electrode terminal of a first cell, and a lower surface of the connection member is arranged to contact the second electrode terminal (223a) forming a lower electrode terminal of an adjacent second cell.

11. The photoelectric module of claim 10, further comprising a support (225) disposed on the second substrate forming a lower substrate (220) of the first cell for supporting a lower surface of the connection member (250) at the first cell.

12. The photoelectric module of claim 11, wherein the lower substrate (220) is longer than the upper substrate (210) and extends to form a base for the support (225).

13. The photoelectric module of claim 11 or 12, wherein the support comprises the same material as the electrode on the lower substrate and is spaced apart from and electrically isolated from the electrode on the lower substrate (223).
